# EUROPEAN PATENT APPLICATION

(11) **EP 4 425 225 A1**
(43) Date of publication of application: **04.09.2024**
(21) Application number: 22886820.4
(22) Date of filing: 19.10.2022
(51) Int. Cl.: G02B 5/00, H01L 27/146

(54) **LIGHT-SHIELDING FILM, OPTICAL COMPONENT, LID BODY, ELECTRONIC COMPONENT MOUNTING PACKAGE, AND IMAGING DEVICE**

(30) Priority: 29.10.2021 JP 2021177037
(71) Applicant: Kyocera Corporation, Kyoto-shi, Kyoto 612-8501 (JP)
(72) Inventor: MAEDA, Junki, Kyoto-shi, Kyoto 612-8501 (JP)
(74) Representative: Viering, Jentschura & Partner mbB Patent- und Rechtsanwälte
(86) International application number: PCT/JP2022/038910
(87) International publication number: WO 2023/074492

(57) **Abstract**

A light shielding film includes: a first surface; and a second surface opposite to the first surface. The light shielding film contains resin, carbon black, and first-type graphite fillers, and longitudinal directions of the first-type graphite fillers are substantially parallel to at least one surface of the first surface and the second surface in a longitudinal section.

## Description

### TECHNICAL FIELD

The present disclosure relates to a light shielding film, an optical member, a lid, a package for mounting an electronic component, and an imaging device.

### BACKGROUND OF INVENTION

Japanese Unexamined Patent Application Publication No. 2007-115921 describes a light shielding film containing carbon black and a solid-state imaging element including the light shielding film.

### SUMMARY

### SOLUTION TO PROBLEM

According to the present disclosure, a light shielding film includes a first surface and a second surface opposite to the first surface. The light shielding film contains resin, carbon black, and first-type graphite fillers. Longitudinal directions of the first-type graphite fillers are substantially parallel to at least one surface of the first surface and the second surface in a longitudinal section.

According to the present disclosure, an optical component includes an optical member and the light shielding film described above. The optical member includes a third surface. The light shielding film described above is located on the third surface.

According to the present disclosure, a lid includes a base portion and the light shielding film described above. The base portion includes a fourth surface. The light shielding film described above is located on the fourth surface.

According to the present disclosure, a package for mounting an electronic component includes a mounting portion, an opening portion, and the light shielding film described above. On the mounting portion, an electronic component is mounted. The opening portion allows light to pass through.

According to the present disclosure, an imaging device includes the package for mounting an electronic component, described above, and an imaging element. The imaging element is mounted on the package for mounting an electronic component.

### BRIEF DESCRIPTION OF THE DRAWINGS

FIG. 1A is a plan view of an optical component according to Embodiment 1 of the present disclosure.
FIG. 1B is a sectional view taken along line B1-B1 in FIG. 1A.
FIG. 2 is a longitudinal sectional view of a light shielding film according to the embodiment of the present disclosure.
FIG. 3 is a diagram for explaining a first effect of graphite fillers.
FIG. 4 is a diagram for explaining a second effect of the graphite fillers.
FIG. 5 is a diagram for explaining a third effect of the graphite fillers.
FIG. 6 is a diagram for explaining a fourth effect of the graphite fillers.
FIG. 7 is a graph illustrating the relationship between the graphite-filler content and the reflectance of a light shielding film.
FIG. 8 is a diagram illustrating the distribution of first- to third-type graphite fillers in a longitudinal section of the light shielding film.
FIG. 9 is a graph illustrating the transmittance of a light shielding film according to the embodiment.
FIG. 10 is a graph illustrating the reflectance of a light shielding film according to the embodiment.
FIG. 11 is a perspective view of a graphite filler.
FIG. 12A is a plan view of an optical component according to Embodiment 2 of the present disclosure.
FIG. 12B is a longitudinal sectional view taken along line B2-B2 in FIG. 12A.
FIG. 13A is an exploded perspective view of a package for mounting an electronic component and an imaging device according to an embodiment of the present disclosure.
FIG. 13B is a sectional view of the package for mounting an electronic component and the imaging device according to the embodiment of the present disclosure.

### DESCRIPTION OF EMBODIMENTS

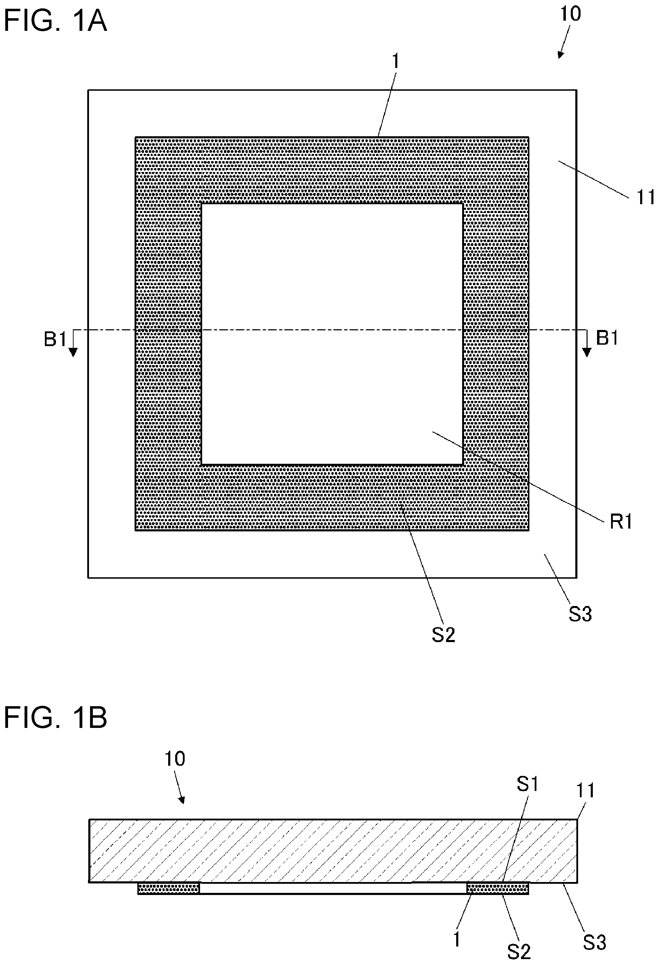

Hereinafter, an embodiment of the present disclosure will be described in detail with reference to the drawings. FIG. 1A is a plan view of an optical component according to Embodiment 1 of the present disclosure. FIG. 1B is a sectional view taken along line B1-B1 in FIG. 1A.

A light shielding film 1 according to the embodiment of the present disclosure includes a first surface S1 configured to be irradiated with light and a second surface S2 opposite to the first surface S1 and is configured to reduce the amount of light transmitted and reflected. The light shielding film 1 is indicated by hatching in FIGs. 1A and 1B.

The optical component 10 according to Embodiment 1 of the present disclosure includes an optical member 11 including a third surface S3 and the light shielding film 1. Although the optical member 11 may be plate-shaped as illustrated in FIGs. 1A and 1B, the optical member 11 may have another shape such as a prism shape or a lens shape. The optical member 11 is a member having a light transmission property (such as glass), and part of the third surface S3 may be a surface that allows light to pass through. The optical member 11 may be another member such as an optical filter member that acts based on the wavelength, polarization plane, incident angle, and the like of light. Alternatively, the optical member 11 may be a mirror that reflects light on part of the third surface S3.

The light shielding film 1 is located on the third surface S3 of the optical member 11. The light shielding film 1 may be fixed to the third surface S3 of the optical member 11. The light shielding film 1 may be located around a light transmission region R1 that allows light to pass through as illustrated in FIG. 1A or may be located in various other portions where a light shielding property is necessary.

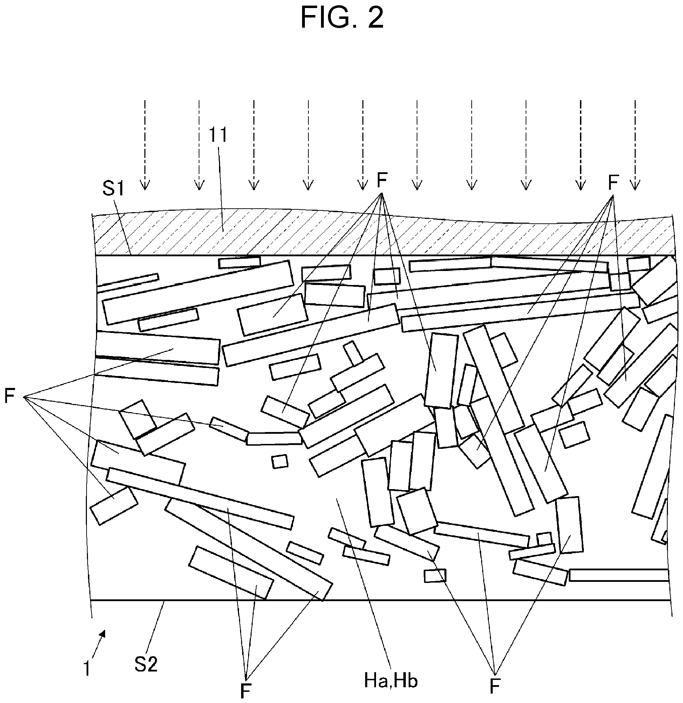

FIG. 2 is a longitudinal sectional view of a light shielding film according to the embodiment of the present disclosure. In FIGs. 2 to 6, the dashed dotted lines with arrows indicate radiated light. A longitudinal section of the light shielding film 1 refers to a section of the light shielding film 1 cut in a thickness direction of the film (a direction perpendicular to the film surfaces). The light shielding film 1 contains resin Ha, carbon black Hb, and a plurality of graphite fillers F. In FIG. 2, only some of the plurality of graphite fillers F are denoted by symbols to avoid the complication of the figure.

The resin Ha may be a thermosetting resin or an epoxy resin. This configuration reduces the amount of outgassing (gas generated by heating after curing).

The carbon black Hb may be mixed with the resin Ha so as to be uniformly distributed in the resin Ha. The carbon black Hb mixed with the resin Ha has a property of reducing the amount of light transmission, a property of reducing the amount of light reflection, and a property of absorbing light in a wide wavelength range.

The graphite fillers F may be in the form of flakes. In the longitudinal section of the light shielding film 1, each graphite filler F has a shape long in one direction in most cases. The graphite fillers F have a property of reducing the amount of light transmission, a property of reducing the amount of light reflection, and a property of absorbing light in a wide wavelength range.

The carbon black Hb mixed with the resin Ha has a higher light absorption rate than the graphite fillers F. When the thickness of the resin Ha containing the carbon black Hb is the same as that of a graphite filler F, the graphite filler F has a lower light transmittance than the carbon black Hb mentioned above.

### <Location Structure of Graphite Fillers in Longitudinal Section>

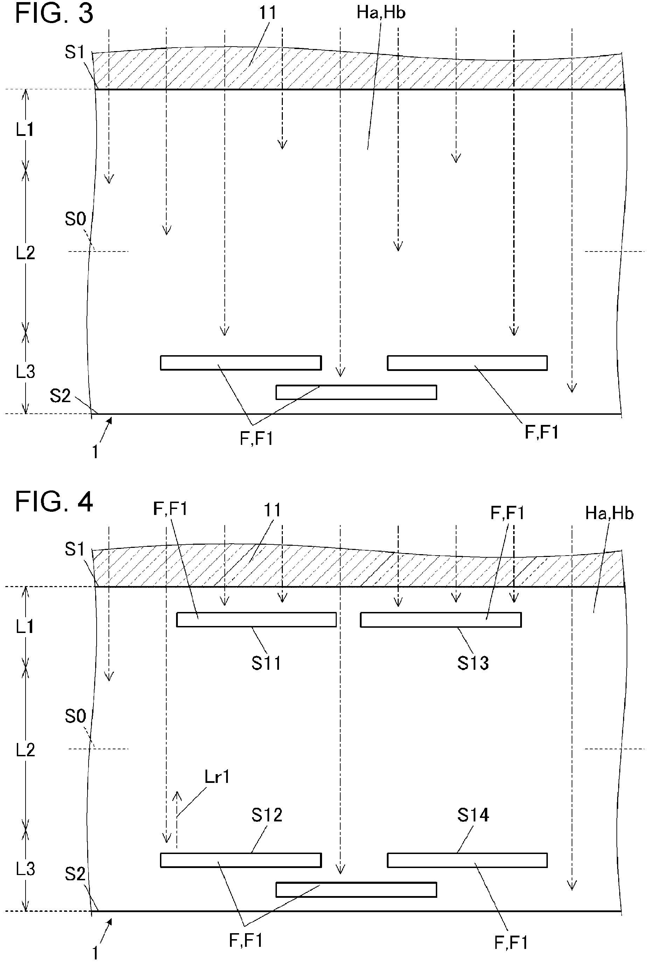

FIGs. 3 to 6 are diagrams for explaining the locations and effects of graphite fillers.

The light shielding film 1 may contain first-type graphite fillers F1 the longitudinal directions of which are substantially parallel to at least one surface (hereinafter, this surface is referred to as "one film surface") of the first surface S1 and the second surface S2 in the longitudinal section (see FIGs. 3 to 6). The graphite fillers F having such an orientation are referred to as "first-type graphite fillers F1". The state in which the longitudinal direction is substantially parallel to the one film surface refers to the state in which the longitudinal direction is within ±30° relative to a direction parallel to the one film surface. The longitudinal direction of a graphite filler F refers to the direction of the straight line connecting one end and the other end of the graphite filler F in the longitudinal direction.

Since the light shielding film 1 contains the first-type graphite fillers F1, wide surfaces of the first-type graphite fillers F1 receive the light entering the light shielding film 1 in the thickness direction, which efficiently reduces the light transmittance of the light shielding film 1. In other words, the first-type graphite fillers F1 contained enable the light transmittance of the light shielding film 1 to be reduced with a small amount of graphite fillers F.

First-type graphite fillers F1 may be located in a third layer L3 which is closer to the second surface S2 with respect to a center plane S0 between the first surface S1 and the second surface S2 of the light shielding film 1 (see FIGs. 3 to 6). In this configuration, the carbon black Hb mixed with the resin Ha absorbs the light having entered the light shielding film 1 through the first surface S1. When the light having entered reaches the third layer L3, the first-type graphite fillers F1 in the third layer L3 block the light at the wide surfaces, which significantly reduces the amount of light passing through the light shielding film 1. Thus, the light shielding film 1 can have a reduced transmittance. In addition, although illustration is omitted, the first-type graphite fillers F1 have a large number of irregularities on their surfaces. Since first-type graphite fillers F1 are located in the third layer L3, the irregular shapes on the surfaces of the first-type graphite fillers F1 are exposed on the second surface S2 of the light shielding film 1, making the second surface S2 a rough surface. The roughness of the surface reduces the surface reflection on the second surface S2. Thus, even when part of the light having passed through the optical component 10 becomes stray light and returns to the second surface S2 of the light shielding film 1, this configuration reduces reflection of the light and thereby reduces stray light.

In addition, first-type graphite fillers F1 may be located in a first layer L1 which is closer to the first surface S1 with respect to the center plane S0 between the first surface S1 and the second surface S2 of the light shielding film 1 (see FIGs. 4 to 6). The first-type graphite fillers F1 located in the first layer L1 significantly reduces the light transmittance near the first surface S1, and thereby makes it possible to achieve a thinner light shielding film 1 with a transmittance of a specified value or less. The first-type graphite fillers F1 located in the first layer L1 make the first surface S1 of the light shielding film 1 a rough surface, reducing the reflectance of the first surface S1. Thus, this configuration reduces the transmittance and the reflectance of the light shielding film 1.

The surfaces of the first-type graphite fillers F1 located in the first layer L1, the surfaces being parallel to their longitudinal directions, and the surfaces of the first-type graphite fillers F1 located in the third layer L3, the surfaces being parallel to their longitudinal directions, may face one another (see FIGs. 4 to 6). In FIGs. 4 to 6, a surface S11 and a surface S12 face each other, and a surface S13 and a surface S14 face each other. With this configuration in which these surfaces face one another, even when light enters the inside through the first surface S1 beyond the first-type graphite fillers F1 in the first layer L1, the first-type graphite fillers F1 in the third layer L3 block most of the light. Thus, the amount of light passing through the light shielding film 1 can be reduced. In addition, the light confined between the first-type graphite fillers F1 in the first layer L1 and the first-type graphite fillers F1 in the third layer L3 (see a light beam Lr1) is absorbed by the carbon black Hb between these fillers. Thus, this configuration further reduces the transmittance and the reflectance of the light shielding film 1.

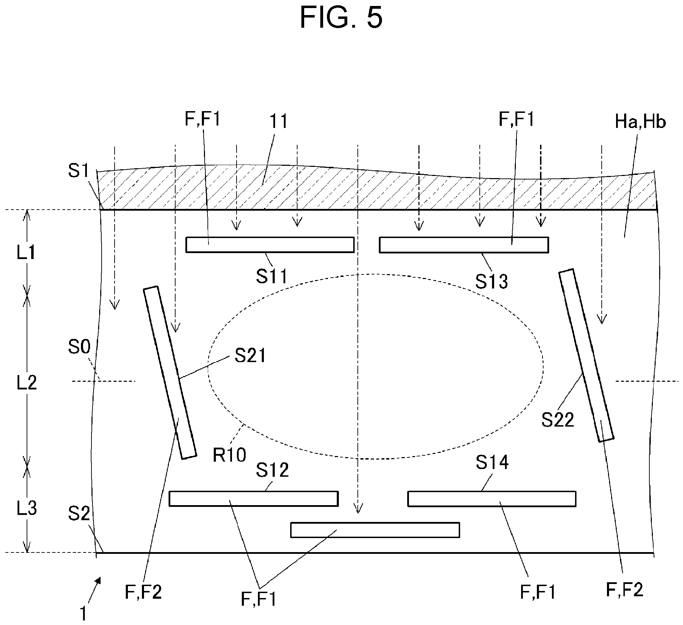

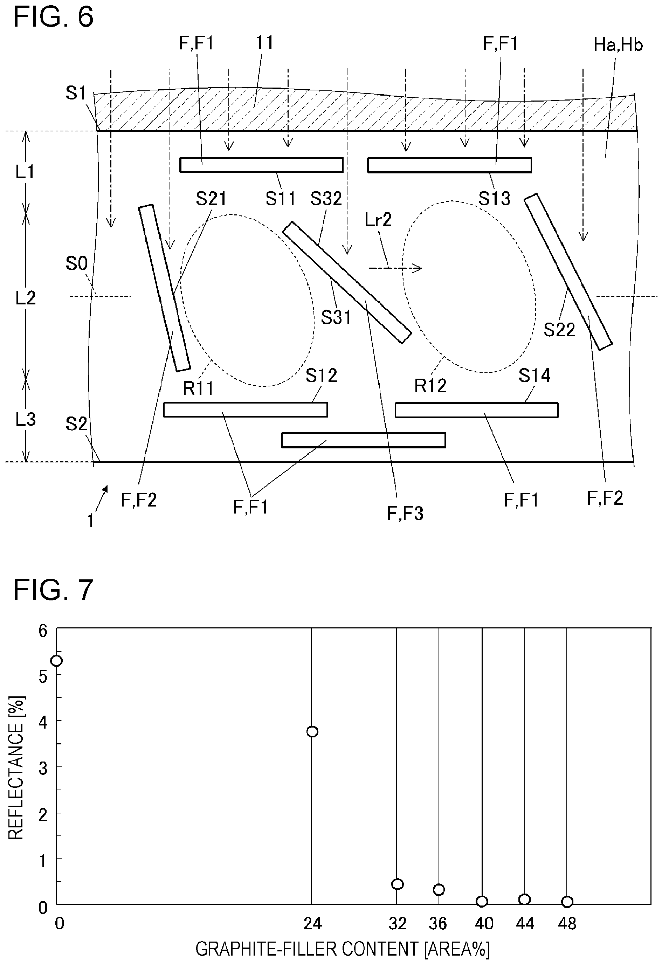

The light shielding film 1 may contain second-type graphite fillers F2 the longitudinal directions of which are substantially parallel to the thickness direction of the light shielding film 1 in the longitudinal section (see FIGs. 5 and 6). The graphite fillers F having such an orientation are referred to as "second-type graphite fillers F2". The state described above in which the longitudinal direction is substantially parallel to the thickness direction refers to the state in which the longitudinal direction is within ±30° relative to the thickness direction. The second-type graphite fillers F2 contained enable the light having entered the inside of the light shielding film 1 beyond the first-type graphite fillers F1 in the first layer L1 to be blocked also in the lateral direction by the second-type graphite fillers F2. Thus, this configuration reduces the light leaking out of the light shielding film 1 through any portions.

The surfaces of the plurality of second-type graphite fillers F2, the surfaces being parallel to their longitudinal directions, may be located so as to face one another (see FIGs. 5 and 6). In FIGs. 5 and 6, a surface S21 and a surface S22 face each other. In this configuration in which these surfaces face each other, the light having entered the inside of the light shielding film 1 beyond the first-type graphite fillers F1 in the first layer L1 is flanked by the plurality of second-type graphite fillers F2 in the lateral direction and can be confined therebetween. The carbon black Hb present therebetween absorbs the light, thereby reducing the amount of light leaking out of the film. Thus, this configuration further reduces the transmittance and the reflectance of the light shielding film 1.

The light shielding film 1 may further contain third-type graphite fillers F3 the longitudinal directions of which are inclined at intermediate angles between the thickness direction of the light shielding film 1 and a direction parallel to the above one film surface in the longitudinal section (see FIG. 6). The graphite fillers F oriented in these directions are referred to as "third-type graphite fillers F3". The state in which the longitudinal direction is inclined at an intermediate angle mentioned above refers to the state in which the longitudinal direction is at an angle greater than 30° and less than 60° relative to the thickness direction of the light shielding film 1.

Since the light shielding film 1 contains the third-type graphite fillers F3, light having entered the inside of the light shielding film 1 is reflected on the third-type graphite fillers F3 and tends to propagate in directions substantially parallel to the film surfaces and be absorbed by the carbon black Hb while propagating (see a light beam Lr2). Thus, this configuration further reduces the transmittance and the reflectance of the light shielding film 1.

The light shielding film 1 may contain a plurality of graphite fillers F such that the graphite fillers F surround part of the carbon black Hb and part of the resin Ha in the longitudinal section (see FIGs. 5 and 6). The graphite fillers F surrounding part of the carbon black Hb and part of the resin Ha may be at least two types (two kinds) of graphite fillers F selected from the group consisting of the first-type graphite fillers F1, the second-type graphite fillers F2, and the third-type graphite fillers F3. In FIG. 5, the plurality of graphite fillers F including the surfaces S21, S11, S13, S22, S14, and S12 surrounds a region R10 of the resin Ha. In FIG. 6, the plurality of graphite fillers F including the surfaces S11, S21, S12, and S31 surrounds a region R11 of the resin Ha. Similarly, the plurality of graphite fillers F including the surfaces S13, S22, S14, and S32 surrounds a region R12 of the resin Ha. In this configuration, the light having entered the region R10, R11, or R12 surrounded by the plurality of graphite fillers F is confined inside the region R10, R11, or R12 and tends to be absorbed by the carbon black Hb in each region. Thus, this configuration further reduces the transmittance and the reflectance of the light shielding film 1.

### <Detailed Example 1 of Light Shielding Film>

The area ratio of graphite fillers F in the longitudinal section of the light shielding film 1 may be from 32% to 48%, preferably from 36% to 44%, or more preferably from 38% to 42%. Graphite fillers F having an area ratio of 32% or more sufficiently reduce the transmittance of the light shielding film 1 by the effect of the graphite fillers F that reduces the amount of light transmission. In addition, graphite fillers F having an area ratio of 32% or more provide an effect of sufficiently roughening the surfaces of the light shielding film 1, thereby reducing the surface reflection of the light shielding film 1. When the area ratio of graphite fillers F increases to 36% or more or 38% or more, the transmittance reducing effect and the surface-reflection reducing effect described above increase.

FIG. 7 is a graph illustrating the relationship between the graphite-filler content and the reflectance of the light shielding film. The graph illustrates the results obtained by measuring the reflectance of a plurality of light shielding films 1 having the same thickness, 20 µm, and different graphite-filler F contents in a wavelength range of ultraviolet and visible light. As illustrated in the graph of FIG. 7, the light shielding films 1 containing graphite fillers F with an area ratio of 32% or more have a low reflectance.

When the area ratio of graphite fillers F is 48% or less, the resin Ha containing the graphite fillers F before curing has moderate fluidity, and this improves the work efficiency of printing the light shielding film 1. When the area ratio of graphite fillers F decreases to 44% or less or 42% or less, the work efficiency mentioned above is more improved.

The area ratio of graphite fillers F/the mass ratio of graphite fillers F ≈ 1.6.

The thickness of the light shielding film 1 may be from 10 µm to 25 µm, preferably from 12 µm to 20 µm, or more preferably from 14 µm to 18 µm. With the fluidity of the resin Ha having a graphite-filler F content mentioned above, the light shielding film 1 having a film thickness mentioned above can be manufactured by a smaller number of printing processes (for example, once) and with less printing unevenness. The light shielding film 1 having a film thickness mentioned above provides a sufficiently low light transmittance.

More specifically, the area ratio of first-type graphite fillers F1 (the graphite fillers F the longitudinal directions of which are substantially parallel to the one film surface) in the longitudinal section may be from 16% to 25%, preferably from 18% to 23%, or more preferably from 19% to 22%.

The area ratio of second-type graphite fillers F2 (the graphite fillers F the longitudinal directions of which are substantially parallel to the thickness direction of the film) in the longitudinal section may be from 7.5% to 11.5%, preferably from 8.5% to 10.5%, or more preferably from 9.0% to 10.0%.

The area ratio of third-type graphite fillers F3 (the graphite fillers F the longitudinal directions of which are inclined at intermediate angles) in the longitudinal section may be from 7.5% to 11.5%, preferably from 8.5% to 10.5%, or more preferably from 9.0% to 10.0%.

The sum of the area ratios of second-type graphite fillers F2 and third-type graphite fillers F3 in the longitudinal section may be from 15% to 23%, preferably from 17% to 21%, or more preferably from 18% to 20%.

The mixing ratios mentioned above increase the effects of graphite fillers F described with reference to FIGs. 3 to 6.

### <Detailed Example 2 of Light Shielding Film>

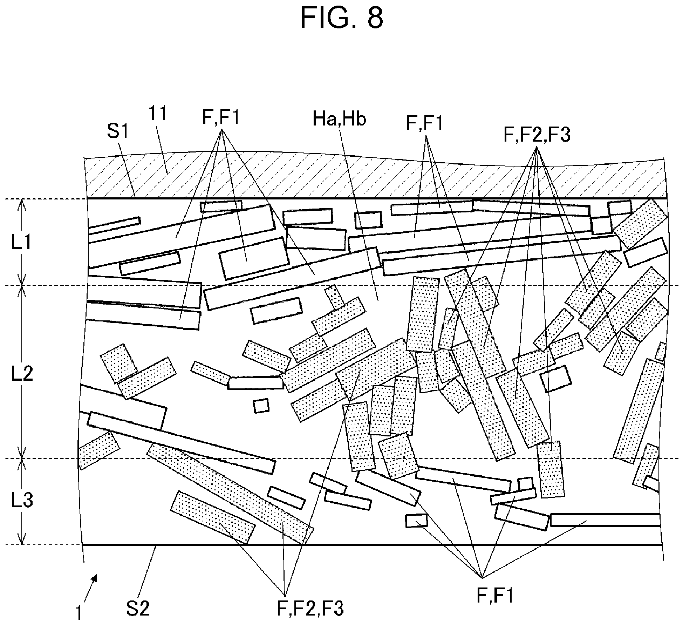

FIG. 8 is a diagram illustrating the distribution of the first- to third-type graphite fillers in a longitudinal section of a light shielding film. In this figure, the first-type graphite fillers F1 are marked in white, and the second- and third-type graphite fillers F2 and F3 are indicated by hatching. The first-type graphite fillers F1 are graphite fillers F the longitudinal directions of which are substantially parallel to one film surface (the longitudinal directions are within ±30° relative to the direction parallel to the one film surface). The second-type graphite fillers F2 are graphite fillers F the longitudinal directions of which are substantially parallel to the thickness direction of the film (at 0° or more and less than 30° relative to the thickness direction). The third-type graphite fillers F3 are graphite fillers F the longitudinal directions of which are inclined at intermediate angles between the thickness direction of the light shielding film 1 and the direction parallel to the one film surface described above.

In terms of the area ratio in the longitudinal section, the mixing ratio between the first-type graphite fillers F1 and the second- and third-type graphite fillers F2 and F3 may have the following relationship in each layer (L1 to L3) of the light shielding film 1. Specifically, in the first layer L1, the area ratio of the first-type graphite fillers F1 may be higher than the sum of the area ratios of the second- and third-type graphite fillers F2 and F3. In the third layer L3, the area ratio of the first-type graphite fillers F1 may be higher than the sum of the area ratios of the second- and third-type graphite fillers F2 and F3. In the second layer L2, the sum of the area ratios of the second- and third-type graphite fillers F2 and F3 may be higher than the area ratio of the first-type graphite fillers F1.

The first layer L1 includes the film surface on the light incident side and has a one-fourth the thickness of the light shielding film 1. The third layer L3 includes the film surface on the light exit side and has one-fourth the thickness of the light shielding film 1. The second layer L2 is located between the first layer L1 and the third layer L3.

In terms of light in the visible light range, this configuration enables the wide surfaces of the first-type graphite fillers F1 in the first layer L 1 to block entering light, thereby sufficiently reducing the light transmittance. The second surface S2 has irregularities due to the presence of the first-type graphite fillers F1 in the third layer L3, and thus the second surface S2 is a rough surface, which reduces the reflectance of the film surface. When the first surface S1 is not in close contact with a member (such as the optical member 11), the first surface S1 can also be a rough surface, thereby reducing the reflectance of the film surface.

In terms of light in a near-infrared region and a short wavelength infrared region, a certain ratio of light passes through the first-type graphite fillers F1 in the first layer L1 due to diffraction and the like. However, such light is confined in regions surrounded by a plurality of graphite fillers F in the second layer L2 and in the third layer L3 and the carbon black Hb contained in these regions absorbs the light. These effects sufficiently reduce the transmittance and the reflectance of the light shielding film 1 also in the near-infrared region and the short wavelength infrared region.

The thickness of the light shielding film 1 may be twice or more the average maximum dimension of the graphite fillers F in the longitudinal direction in the longitudinal section. The average maximum dimension of the graphite fillers F in the longitudinal direction refers to the average of the top from 90% to 98% of the dimensions of the graphite fillers F in the longitudinal direction in a region including a large number of graphite fillers F in a longitudinal section. When the average maximum dimension of the graphite fillers F in the longitudinal direction is from 4 µm to 6 µm, a film thickness from 10 µm to 25 µm satisfies the above condition.

With a film thickness mentioned above, the longitudinal directions of the graphite fillers F in the second layer L2 tend to be at less than ±60° relative to the thickness direction of the film. Hence, the number of the second- and third-type graphite fillers F2 and F3 tends to be larger than that of the first-type graphite fillers F1 in the second layer L2.

### <Optical Properties of Light Shielding Film>

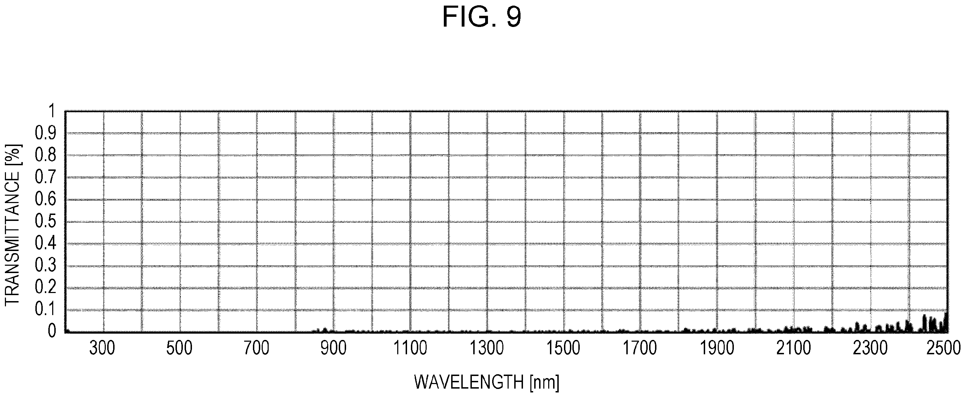

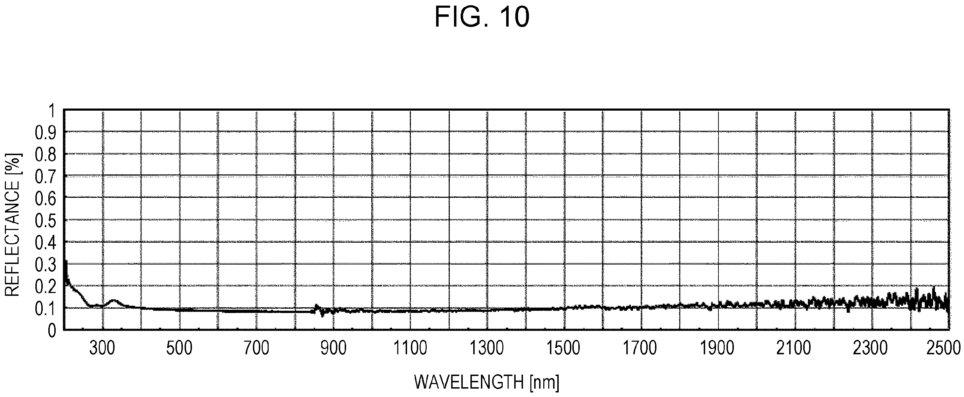

FIG. 9 is a graph illustrating the transmittance of a light shielding film according to the embodiment. FIG. 10 is a graph illustrating the reflectance of a light shielding film according to the embodiment. The two graphs illustrate properties of a light shielding film 1 with a thickness of 20 µm.

As illustrated in FIG. 9, the light transmittance of the light shielding film 1 may be less than 0.2% in the range from the ultraviolet region to the short wavelength infrared region (from 250 nm to 2500 nm). As illustrated in FIG. 10, the light reflectance of the light shielding film 1 may be less than 0.5% in the range from the ultraviolet region to the short wavelength infrared region (from 250 nm to 2500 nm).

With a transmittance and a reflectance described above, the light shielding film 1, when used in various optical elements, can sufficiently block unnecessary light. For example, consider a case in which the optical element is an imaging element, in which the light shielding film 1 is located so as to surround the light incident range in front of the imaging element, and in which the imaging element has a sensitivity in a range beyond the visible light wavelength range up to the ultraviolet region or the infrared region. In such a case, the light shielding film 1 with the transmission property and the reflection property described above can reduce the effects of flare or ghost on the signals of the imaging element.

### <Description of Locations and Effects of Graphite Fillers When Viewed Three-Dimensionally>

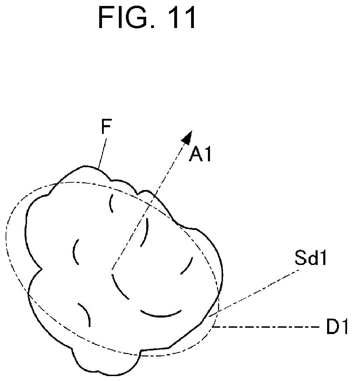

The locations and effects of the graphite fillers F when the light shielding film 1 is viewed three-dimensionally will be described. FIG. 11 is a perspective view of a graphite filler. As illustrated in FIG. 11, the graphite filler F may have a flake shape (a deformed circular shape including irregularities). Each graphite filler F can be represented by a flat disk D1 which is closest in shape. For example, the above representation may be performed by using the least square method. In the following, the center axis A1 and the disk surface Sd1 of the flat disk D1 are referred to as the center axis A1 and the disk surface Sd1 of a graphite filler F.

The light shielding film 1 may contain graphite fillers F the disk surfaces Sd1 of which are substantially parallel to at least one surface of the first surface S1 and the second surface S2 (hereinafter, this surface is referred to as "one film surface") (see FIGs. 3 to 6). The definition of the graphite fillers F having such an orientation differs from that of the first-type graphite fillers F1 described earlier, but these are approximately the same as and/or similar to the first-type graphite fillers F1 described earlier. Hence, also the graphite fillers F having such an orientation are referred to as first-type graphite fillers F1. The state in which the disk surface Sd1 is substantially parallel to one film surface refers to the state in which the acute angle formed between the center axis A1 of the graphite filler F and the normal line of the one surface is within 30°. The first-type graphite fillers F1 contained enable light entering the light shielding film 1 in the thickness direction to be received by the wide surfaces of the first-type graphite fillers F1, thereby efficiently reducing the light transmittance of the light shielding film 1. In other words, the first-type graphite fillers F1 contained enable the light transmittance of the light shielding film 1 to be reduced with a small amount of graphite fillers F.

First-type graphite fillers F1 may be located in the third layer L3 of the light shielding film 1 (see FIGs. 3 to 6). The first-type graphite fillers F1 located in the third layer L3 enable the light having entered the inside of the light shielding film 1, even if advancing without being absorbed by the carbon black Hb, to be blocked by the first-type graphite fillers F1 near the second surface S2, thereby reducing the light passing through the light shielding film 1. Since each first-type graphite filler F1 has a large number of irregularities on its surfaces, the irregular shapes on the surfaces of the first-type graphite fillers F1 located in the third layer L3 are exposed on the second surface S2, thereby making the second surface S2 a rough surface. The surface roughness reduces the surface reflection on the second surface S2, thereby reducing the reflectance of the light shielding film 1.

First-type graphite fillers F1 may be located also in the first layer L 1 of the light shielding film 1 (see FIGs. 4 to 6). The wide surfaces of the first-type graphite fillers F1 located in the first layer L1 block entrance of light near the first surface S1, thereby reducing the transmittance of the light shielding film 1. When the first surface S 1 of the light shielding film 1 is not in close contact with a member or the like, irregularities of the first-type graphite fillers F1 located in the first layer L1 make the first surface S1 a rough surface, thereby reducing surface reflection on the first surface S1. Thus, this configuration reduces the transmittance and the reflectance of the light shielding film 1.

The disk surfaces Sd1 of the first-type graphite fillers F1 located in the first layer L1 and those of the first-type graphite fillers F1 located in the third layer L3 may face one another (see FIGs. 4 to 6). In other words, in transparent view perpendicular to the surfaces of the light shielding film 1, the first-type graphite fillers F1 in the first layer L1 and the first-type graphite fillers F1 in the third layer L3 may be located so as to overlap one another. In FIG. 4, the disk surfaces Sd1 mentioned above correspond to the surfaces S11 to S14. In FIGs. 5 and 6, the disk surfaces Sd1 mentioned above correspond to the surfaces S11 to S14.

With this configuration, even when the light entered through the first surface S1 advances inside beyond the first-type graphite fillers F1 in the first layer L1, the first-type graphite fillers F1 in the third layer L3 block most of the light, and this reduces the light passing through the light shielding film 1. In addition, the light confined between the first-type graphite fillers F1 in the first layer L1 and the first-type graphite fillers F1 in the third layer L3 is absorbed by the carbon black Hb enclosed by these fillers. Thus, this configuration further reduces the transmittance and the reflectance of the light shielding film 1.

The light shielding film 1 may contain graphite fillers F the disk surfaces Sd1 of which are substantially parallel to the thickness direction of the light shielding film 1 (see FIGs. 5 and 6). The definition of the graphite fillers F having such an orientation differs from that of the second-type graphite fillers F2 described earlier, but these are approximately the same as and/or similar to the second-type graphite fillers F2 described earlier. Hence, also the graphite fillers F having such an orientation are referred to as the second-type graphite fillers F2. The state in which the disk surface Sd1 is substantially parallel to the thickness direction of the light shielding film 1 is defined as the state in which the acute angle formed between the center axis A1 of a graphite filler F and the normal line of a film surface of the light shielding film 1 is from 60° to 90°. The second-type graphite fillers F2 contained enable the light having entered the inside of the light shielding film 1 beyond the first-type graphite fillers F1 in the first layer L1 to be blocked also in directions substantially parallel to the film surface by the second-type graphite fillers F2. Thus, this configuration reduces the amount of such light leaking out of the light shielding film 1 through any portions.

The plurality of second-type graphite fillers F2 may be located such that their disk surfaces Sd1 face one another (see FIGs. 5 and 6). The term "face" mentioned above refers to the state in which in transparent view in the center axis A1 direction of one second-type graphite filler F2, the disk surface Sd1 of the one second-type graphite filler F2 overlaps the disk surface Sd1 of another second-type graphite filler F2. The term "face" mentioned above may also refer to the state in which the acute angle formed between the center axis A1 of one second-type graphite filler F2 and the center axis A1 of another second-type graphite filler F2 is 45° or less, and in which the center axis A1 of the one second-type graphite filler F2 intersects the disk surface Sd1 of the other second-type graphite filler F2. In FIGs. 5 and 6, the disk surfaces Sd1 of second-type graphite fillers F2 facing each other correspond to the surfaces S21 and S22.

In the configuration in which the disk surfaces Sd1 of second-type graphite fillers F2 face one another, the light having entered the inside of the light shielding film 1 beyond the first-type graphite fillers F1 in the first layer L1 is flanked by a plurality of second-type graphite fillers F2 in the lateral direction. Thus, the light can be confined therebetween. The confined light is absorbed by the carbon black Hb present therebetween, and the amount of light leaking out of the film can be reduced. Thus, this configuration reduces the transmittance and the reflectance of the light shielding film 1.

The light shielding film 1 may further contain graphite fillers F the disk surfaces Sd1 of which are inclined at intermediate angles between the thickness direction of the light shielding film 1 and directions parallel to the one film surface (see FIG. 6). The definition of the graphite fillers F having such orientations differs from that of the third-type graphite fillers F3 described earlier, but these are approximately the same as and/or similar to the third-type graphite fillers F3 described earlier. Hence, also the graphite fillers F having such orientations are referred to as the third-type graphite fillers F3. The state mentioned above in which the disk surface Sd1 is inclined at the above intermediate angle refers to the state in which the acute angle formed between the center axis A1 of the graphite filler F and the normal line of a film surface of the light shielding film 1 is from 30° to 60°. Since the light shielding film 1 contains the third-type graphite fillers F3, the light having entered the inside of the light shielding film 1 is reflected on the third-type graphite fillers F3 and tends to propagate in directions parallel to the film surface and be absorbed by the carbon black Hb while propagating. Thus, this configuration further reduces the transmittance and the reflectance of the light shielding film 1.

The light shielding film 1 may contain a plurality of graphite fillers F surrounding carbon black Hb and resin Ha in the thickness direction of the film and directions substantially parallel to the film surface (see FIGs. 5 and 6). The state in which the plurality of graphite fillers F surrounds carbon black Hb and resin Ha in directions substantially parallel to the film surface may refer to configurations in which graphite fillers F surround carbon black Hb and resin Ha in three directions or four or more directions substantially parallel to the film surface. The graphite fillers F surrounding carbon black Hb and resin Ha may be at least two types (two kinds) of graphite fillers F selected from the group consisting of the first-type graphite fillers F1, the second-type graphite fillers F2, and the third-type graphite fillers F3. In this configuration, the light having entered the region R10, R11, or R12 surrounded by a plurality of graphite fillers F is confined inside the region and tends to be absorbed by the carbon black Hb in this region. Thus, this configuration further reduces the transmittance and the reflectance of the light shielding film 1.

### <Optical Component>

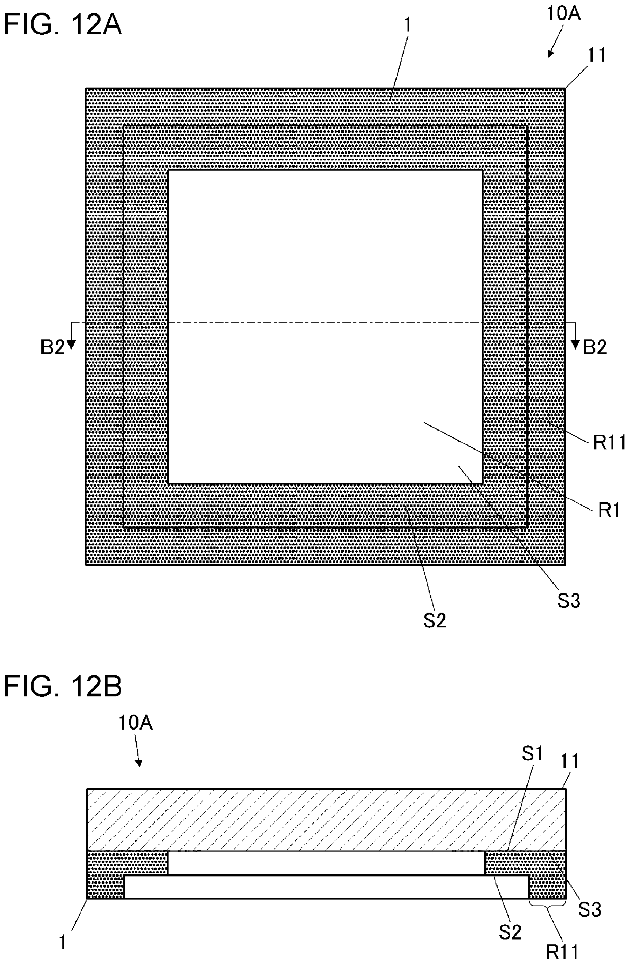

FIG. 12A is a plan view of an optical component according to Embodiment 2 of the present disclosure. FIG. 12B is a longitudinal sectional view taken along line B2-B2 in FIG. 12A.

An optical component 10A of Embodiment 2 includes an optical member 11 including a third surface S3 and a light shielding film 1. The optical member 11 may be plate-shaped as illustrated in FIGs. 12A and 12B. The optical member 11 is a member having a light transmission property (such as glass), and part of the third surface S3 may be a light transmission region R1 that allows light to pass through.

The light shielding film 1 is located on the third surface S3 of the optical member 11. The light shielding film 1 may be fixed to the third surface S3 of the optical member 11. As illustrated in FIG. 12A, the light shielding film 1 may be located around the perimeter of the light transmission region R1 that allows light to pass through, which is at the edges of the third surface S3. The light shielding film 1 has the structure and characteristics described above.

As illustrated in FIG. 12B, the light shielding film 1 may further include a region R11 which is thicker than the other portion. The thick region R11 may have a shape along a closed path surrounding the light transmission region R1. In a possible configuration, the thick region R11 may function as a joining material and be joined to the perimeter of an opening portion of a package before curing, so that the optical component 10A may seal the opening portion.

With the optical component 10A configured as described above, the process of adding a joining material for sealing can be combined with the process of adding the light shielding film 1, which reduces the number of processes to manufacture the optical component 10A, thereby reducing the manufacturing costs of the optical component 10.

### <Package for Mounting Electronic Component and Imaging Device>

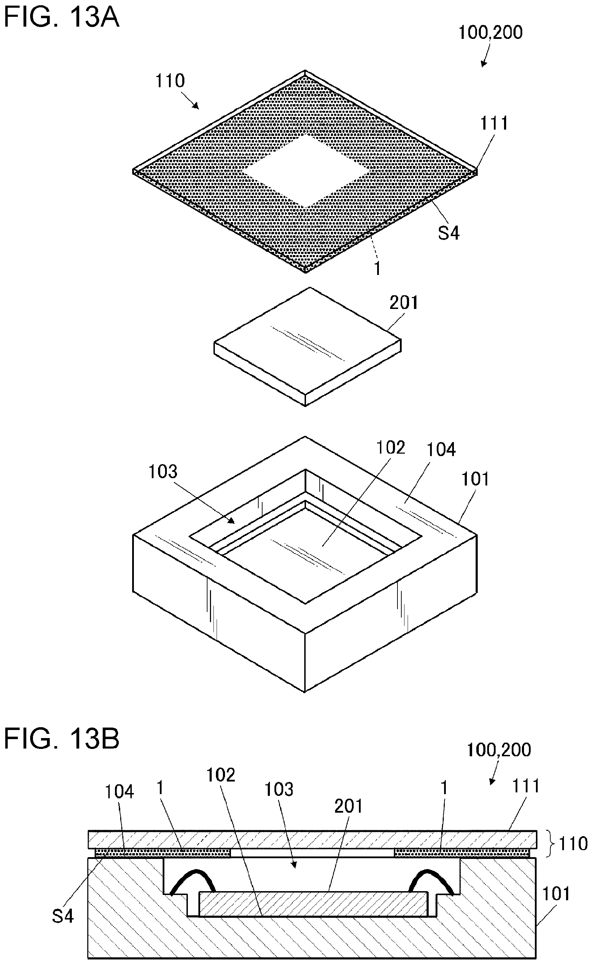

FIG. 13A is an exploded perspective view of a package for mounting an electronic component and an imaging device according to an embodiment of the present disclosure. FIG. 13B is a sectional view of the package for mounting an electronic component and the imaging device according to the embodiment of the present disclosure.

A package 100 for mounting an electronic component, according to the present embodiment includes a base 101 including a mounting portion 102 and an opening portion 103 and also includes a lid 110 for covering the opening portion 103. The mounting portion 102 is where an electronic component 201 is mounted. Part of the opening portion 103 functions as a passage of light. The base 101 includes a recess and the mounting portion 102 in the recess, and the opening of the recess may correspond to the opening portion 103. The base 101 may include a reception portion 104 located around the opening portion 103 and facing the lid 110.

An imaging device 200 of the present embodiment includes the package 100 for mounting an electronic component and the electronic component 201 which is an imaging element.

The base 101 may include an insulation portion made of an insulation material and a conductor portion located inside and on the surface of the insulation portion. In this configuration, electric power, signals, or both may be transferred between the outside and the inside of the base 101 through the conductor portion. The insulation portion may be made of a ceramic material such as an aluminum oxide-based sintered material (alumina ceramic), an aluminum nitride-based sintered material, a mullite-based sintered material, or a glass ceramic sintered material.

The lid 110 includes a base portion 111 including a fourth surface S4 and the light shielding film 1 located on the fourth surface S4. The base portion 111 may be made of a material (such as glass) having a light transmission property. The lid 110 is joined to the reception portion 104 of the base 101. This joining process may be performed by curing of the light shielding film 1. The light shielding film 1 has the structure and characteristics described above.

In the package 100 for mounting an electronic component, according to the present embodiment, the light shielding film 1 can sufficiently reduce unnecessary light entering the mounting portion 102 through the lid 110. In addition, the work efficiency for adding the light shielding film 1 to the base portion 111 of the lid 110 is improved, which improves the yield and reduces the manufacturing costs. In the imaging device 200 of the present embodiment, the light shielding film 1 on the lid 110 reduces radiation of unnecessary light to the electronic component 201, which is an imaging element, thereby reducing the effects of flare or ghost on the signals of the electronic component 201. In addition, since the lid 110 includes the light shielding film 1, the height of the device can be lower than when the lid and the light shielding film are separate members.

The embodiments of the present disclosure have been described above. However, the present disclosure is not limited to the light shielding film 1, the optical components 10 and 10A, the lid 110, the package 100 for mounting an electronic component, and the imaging device 200 in the embodiments described above. Details and the like described in the embodiments can be modified as appropriate within a range not departing from the spirit of the invention.

### INDUSTRIAL APPLICABILITY

The present disclosure is applicable to light shielding films, optical members, lids, packages for mounting an electronic component, and imaging devices.

### REFERENCE SIGNS

1 light shielding film
Ha resin
Hb carbon black
F graphite filler
F1 first-type graphite filler
F2 second-type graphite filler
F3 third-type graphite filler
L1 first layer (layer close to the first surface)
L2 second layer
L3 third layer (layer close to the second surface)
S0 center plane
S1 first surface
S2 second surface
10, 10A optical component
11 optical member
S3 third surface
100 package for mounting an electronic component
101 base
102 mounting portion
103 opening portion
110 lid
111 base portion
S4 fourth surface
200 imaging device
201 electronic component (imaging element)

## Claims

1. Alight shielding film comprising:
a first surface; and
a second surface opposite to the first surface, wherein
the light shielding film comprises resin, carbon black, and first-type graphite fillers, and
longitudinal directions of the first-type graphite fillers are substantially parallel to at least one surface of the first surface and the second surface in a longitudinal section.

2. The light shielding film according to claim 1, wherein
the first surface is a surface configured to be irradiated with light, and
some of the first-type graphite fillers are located in a layer closer to the second surface with respect to a center plane between the first surface and the second surface.

3. The light shielding film according to claim 2, wherein
some of the first-type graphite fillers are also located closer to the first surface with respect to the center plane between the first surface and the second surface.

4. The light shielding film according to any one of claims 1 to 3, further comprising
second-type graphite fillers, wherein
longitudinal directions of the second-type graphite fillers are substantially parallel to a thickness direction of the light shielding film in a longitudinal section.

5. The light shielding film according to claim 4, wherein
surfaces of some of the second-type graphite fillers, the surfaces being parallel to the longitudinal directions of these second-type graphite fillers, face one another in a longitudinal section.

6. The light shielding film according to claim 4 or 5, wherein
some of the first-type graphite fillers and some of the second-type graphite fillers surround part of the resin and part of the carbon black in a longitudinal section.

7. The light shielding film according to any one of claims 1 to 6, further comprising
third-type graphite fillers, wherein
longitudinal directions of the third-type graphite fillers are inclined at intermediate angles between a thickness direction of the light shielding film and a direction parallel to the one surface in a longitudinal section.

8. The light shielding film according to claim 7, wherein
some of the first-type graphite fillers and some of the third-type graphite fillers surround part of the resin and part of the carbon black in a longitudinal section.

9. The light shielding film according to claim 4 or 5, further comprising
third-type graphite fillers, wherein
longitudinal directions of the third-type graphite fillers are inclined at intermediate angles between the thickness direction of the light shielding film and a direction parallel to the one surface in a longitudinal section, and
some of at least two types of graphite fillers selected from the group consisting of the first-type graphite fillers, the second-type graphite fillers, and the third-type graphite fillers surround part of the resin and part of the carbon black in a longitudinal section.

10. An optical component comprising:
an optical member comprising a third surface; and
the light shielding film according to any one of claims 1 to 9, located on the third surface.

11. A lid comprising:
a base portion comprising a fourth surface; and
the light shielding film according to any one of claims 1 to 9, located on the fourth surface.

12. A package for mounting an electronic component, comprising:
a mounting portion on which an electronic component is mounted;
an opening portion that allows light to pass through; and
the light shielding film according to any one of claims 1 to 9.

13. An imaging device comprising:
the package for mounting an electronic component, according to claim 12; and
an imaging element mounted on the package for mounting an electronic component.
